# EUROPEAN PATENT SPECIFICATION

(11) **EP 2 520 003 B1**
(45) Date of publication and mention of the grant of the patent: **30.03.2016**
(21) Application number: 10840577.0
(22) Date of filing: 29.12.2010
(51) Int. Cl.: H02J 7/00, H01M 10/44, H02J 7/35, H01M 10/46

(54) **SOLAR CHARGER FOR CHARGING POWER BATTERY**
SOLARLADEGERÄT ZUM AUFLADEN EINES AKKUMULATORS
CHARGEUR SOLAIRE POUR CHARGER UN ACCUMULATEUR ÉLECTRIQUE

(30) Priority: 31.12.2009 CN 200910260754
(43) Date of publication of application: 07.11.2012
(73) Proprietor: BYD Company Limited, Shenzhen 518118 (CN); Shenzhen BYD Auto R&D Company Limited, Shenzhen, Guangdong 518118 (CN)
(72) Inventor: GUO, Guangxi, Shenzhen, Guangdong 518118 (CN); XU, Yang, Shenzhen, Guangdong 518118 (CN); LIANG, Shulin, Shenzhen, Guangdong 518118 (CN); ZHANG, Jianhua, Shenzhen, Guangdong 518118 (CN)
(74) Representative: Gulde & Partner
(86) International application number: PCT/CN2010/080423
(87) International publication number: WO 2011/079789

(56) References cited:
- EP-A1- 1 993 186
- WO-A1-2009/035995
- CN-A- 1 728 498
- CN-Y- 2 599 851
- CN-Y- 201 023 493
- CN-Y- 201 023 493
- CN-Y- 201 141 544
- US-A1- 2004 066 173

## Description

### BACKGROUND

### TECHNICAL FIELD

The present disclosure relates to an electric vehicle, more particularly, to a solar charger for charging a power battery.

### DESCRIPTION OF THE RELATED ART

Because there are neither power batteries nor solar chargers on the electric bus, the electric bus in the market only drives along the track way with power lines, which is very inconvenient.

It is well known that, solar energy as a new energy has no pollution and is easy to obtain. However, the conventional solaire charger is mostly used for low-power devices such as cell phones, cameras and emergency lamps, but rarely used for high-power devices such as electric buses.

Therefore, how to provide a solar charger used for the high-power devices such at electric buses and vehicles is a question that needs to be solved.

US 2004/066173 A1 cf. the preamble of claim 1 discloses an active switch with a photo transistor controlling a MOSFET switch to connect or disconnect a solar array to a battery.

CN 201 023 493 Y discloses a signal for a railway crossing with a solar battery panel and a battery. Depending on the external light intensity two switches are operated to either activate an LED display or to load the battery.

### SUMMARY

An embodiments of the present disclosure provides a solar charger for charging a power battery, comprising: a photo-sensitive unit configured to detect light intensity; a charging unit configured to receive a voltage transformed from solar energy and to boost the voltage so as to provide the voltage to the power battery; a switch unit coupled between the charging unit and the power battery and configured to disconnect the charging unit from the power battery of connect the charging unit with the power battery; and a control unit coupled to the photo-sensitive unit, the switch unit and the charging unit respectively, and configured to switch on the charging unit and the switch unit when the light intensity is higher than a first predetermined value so as to charge the power battery; wherein the control unit is configured to periodically compare a current light intensity detected by the photo-sensitive unit with the first predetermined value, to switch off the charging unit and the switch unit if the current light intensity is lower than the first predetermined value, and to switch on the charging unit and the switch unit if the current light intensity is higher than the first predetermined value.

By using the aforementioned solar charger, the charging unit may boost the voltage that is inputted into the charging unit and transformed from the solar energy, so as to provide the voltage to the power battery under the control of the control unit, thereby realizing the aim to charge the power battery

### BRIEF DESCRIPTION OF THE DRAWINGS

These and other aspects and advantages of the disclosure will become apparent and more readily appreciated from the following descriptions taken in conjunction with the drawings in which:
Fig. 1 is a schematic diagram of the solar charger according to a first embodiment of the present disclosure;
Fig. 2 is a schematic diagram of the solar charger according to a second embodiment of the present disclosure;
Fig. 3 is a schematic diagram of the solar charger according to a third embodiment of the present disclosure;
Fig. 4 is a schematic diagram of the solar charger according to a fourth embodiment of the present disclosure;
Fig. 5 is a schematic diagram of the solar charger according to a fifth embodiment of the present disclosure;
Fig. 6 is a schematic diagram of the solar charger according to a sixth embodiment of the present disclosure; and
Fig. 7 is a flow chart of the charging process of the solar charger according to an embodiment of the present disclosure.

### DETAILED DESCRIPTION

Reference will be made in detain, to embodiments of the present disclosure. The embodiments described herein with reference to drawings are explanatory and illustrative, and are used to generally understand the present disclosure. The embodiments shall not be construed to limit the present disclosure. The same or similar elements and the elements having same or similar functions are denoted by like reference numerals throughout the descriptions.

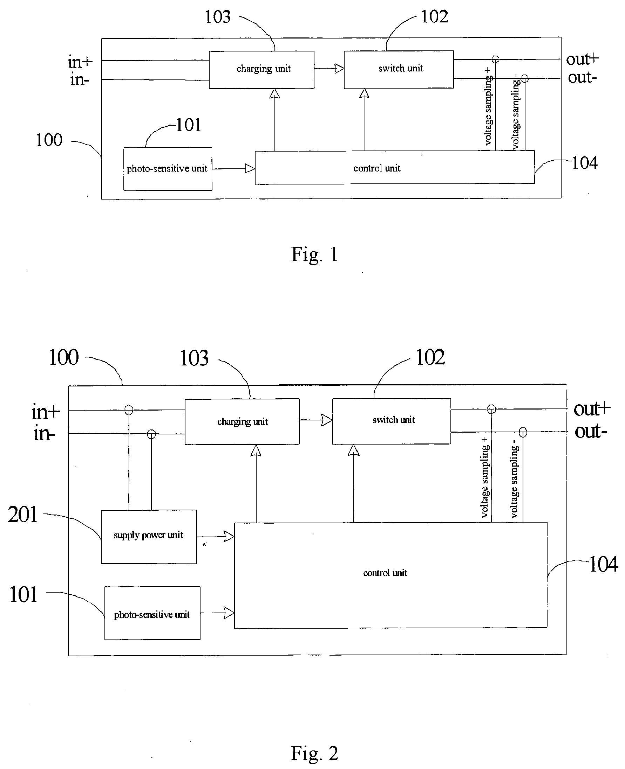

As shown in Fig. 1, in a first embodiment of the present disclosure, the solar charger 100 comprises a photo-sensitive unit 101, a switch unit 102, a charging unit 103 and a control unit 104. The control unit 104 is coupled to the photo-sensitive unit 101, the switch unit 102 and the charging unit 103 respectively.

The photo-sensitive unit 101 is configured to detect the light intensity and to send the light intensity to the control unit 104. For example, the photo-sensitive unit 101 may be a photo-sensitive resistance or other photo-sensitive components.

The switch unit 102 is coupled between the charging unit 103 and the power battery and configured to disconnect the charging unit 103 from the power battery or connect the charging unit 103 with the power battery under the control of the control unit 104. For example, the switch unit 102 may be a relay. When the solar charger 100 satisfies the charging conditions; the control unit 104 may cause the relay to be switched on so as to allow the charging unit 103 to charge the power battery under the control of the control unit 104. When the solar charger 100 does not satisfy the charging conditions, the control unit 104 may cause the relay to be switched off so as to disconnect the charging unit 103 from the power battery, thus the solar charger 100 may not charge the power battery. Moreover, the relay has resistance properties of " excellent insulation when the relay is switched off and has resistance properties of low conduction when the relay is switched on. Therefore, the relay may effectively disconnect the charging unit 103 from the power battery when the relay is switched off, to avoid misoperation of the control unit 104 when a voltage imputted into the charging unit 103 is sampled at the output voltage sampling line (corresponding to the voltage , sampling + arid the voltage sapling - in Fig. 1) when the charging of the power battery is stropped. In addition, the charging performance of the solar charger 100 may not be influenced when the relay is switched on.

The charging unit 103 is configured to receive a voltage that is inputted into the charging unit 103 and transformed from solar energy and to boost the voltage so as to provide the voltage to the power battery under the control of the control unit 104 when the switch unit 102 is switched on. In some embodiments, the device for transforming the solar energy into the voltage may be a solar battery board. Moreover, the charging unit 103 may boost the voltage (for example, 320V) outputted from the solar battery board to the power battery voltage (for example, 570V) which is higher than the voltage (for example, 320V) outputted from the solar battery board, which may realize the aim to charge the power battery.

The control unit 104 is configured to receive the light intensity provided by the photo-sensitive unit 101. When the light intensity is higher than a first predetermined value (for example, a value of no less than 50 lux), the control unit 104 switches on the charging unit 103 and the switch unit 102, thus the charging unit 103 may charge the power battery. The control unit 104 monitors the voltage of the power battery, and switches off the charging unit 103 and the switch unit 102 when the voltage of the power battery reaches a saturation value (for example, 570 V). It should be understood that, here, 570 V is just an example. The saturation value of the power battery may be different values according to the capacities of element cells in the power battery and the number of the element cells. The control unit 104 may monitor the power battery voltage by the voltage samplings at the output end of the solar charger 100 in Fig. 1 (that is, the voltage sampling + and the voltage sampling - in Fig. 1).

As shown in Fig. 1, "in+" and "in-" are a positive input terminal and a negative input terminal of the solar charger 100 respectively, and "out+" and "out-" are a positive output terminal and a negative output terminal of the solar charger 100 respectively. The positive input terminal and the negative input terminal of the solar charger 100 may be coupled to a solar harvesting device (such as the solar battery board) via a service switch (not shown), and the positive output terminal and the negative output terminal may be coupled to the power battery via another service switch (not shown).

By using the solar charger 100; the charging unit 103 may boost the voltage that is inputted into the charging unit 103 and transformed from the solar energy so as to provide the voltage to the power battery under the control of the control unit 104, thereby realizing the aim to charge the power battery.

In a second embodiment of the present disclosure, as shown in Fig. 2, the solar charger 100 further comprises a power battery unit 201 coupled to the control unit 104, and configured to receive and steady the voltage that is inputted into the charging unit 103 and transformed from the solar energy so as to power the control unit 104; and when the voltage transformed from the solar energy reaches a second predetermined value, the control unit 104 starts to work. Thus, when the voltage inputted into the charging unit 103 is lower than the second predetermined value, the control unit 104 may not work, so the solar charger 100 may not work. And only when the voltage inputted into the charging unit 103 is enough high, the solar charger 100 of the present disclosure may start to work, thus having the functions of automatic starting and closing. Moreover, the second predetermined value may be no less than 12 V, such as 80 V. As is known, the value is just an example and the second predetermined value may be different values according to the actual conditions. Typically, only when the voltage inputted into the charging unit 103 is higher than a predetermined value (for example, 100 V), the control unit 104 may switch on the charging unit 103. Therefore, in a preferred embodiment of the present disclosure, the second predetermined value is less than a minimum voltage that is inputted into the charging unit 103 when the control unit 104 switches on the charging unit 103.

In the second embodiment of the present disclosure, the control unit 104 is configured to periodically (for example, at intervals of 30 minutes) switch on the switch unit 102 so as to detect the current voltage of the power battery after the voltage of the power battery reaches a saturation value, and to switch on the charging unit 103 and the switch unit 102 so as to charge the power battery when the current voltage of the power battery is lower than the saturation value (for example, 570 V) and the light intensity detected by the photo-sensitive unit is higher than the first predetermined value. As a result, not only the power battery of an electric bus or vehicle may be charged during the driving process, but also the abrupt change of the output current of the power battery may be retarded during the driving process, thus not only strengthening the endurance performance of the vehicle, but also retarding the damage to the power battery under large current, protecting the performance of the power battery and prolonging the life of the power battery. The periodic time T for periodically switching on the switch unit 102 may be determined according to the capacity and the energy dissipation of the power battery, typically, may be about 10 minutes to about 50 minutes, that is, the control unit 104 switches on the switch unit 102 to detect the current voltage of the power battery at intervals of T.

In the second embodiment of the present disclosure, the control unit 104 is further configured to periodically (for example, every 3 minutes) compare the current light intensity detected by the photo-sensitive unit 101 with the first predetermined value, to switch off the charging unit 103 and the switch unit 102 if the current light intensity is lower than the first predetermined value, and to switch on the charging unit 103 and the switch unit 102 if the current light intensity is higher than the first predetermined value, thus ensuring that the power battery is not charged at low light intensity. In addition, the periodic time for periodically comparing the light intensity with the first predetermined value may be about 0.5 minutes to about 10 minutes.

In the second embodiment of the present disclosure, the control unit 104 is further configured to communicate with an external control device (such as a battery manager or a display device) and to control the charging unit 103 and the switch unit 102 according to instructions from the external control device. For example, the control unit 104 may switch off the charging unit 103 and the switch unit 102 if the control unit 104 receives instructions of fast or slow charging before the solar charger 100 charges the power battery, as a result, the power battery may be charged via a mains supply. If the control unit 104 receives instructions of fast or slow charging during the charging process of the solar charger 100 for the power battery, the control unit 104 may switch off the charging unit 103 and the switch unit 102, as a result, the power battery may be charged via the mains supply. Therefore, the solar charger 100 of the present disclosure may satisfy various needs for charging, for example, fast charging or slow charting.

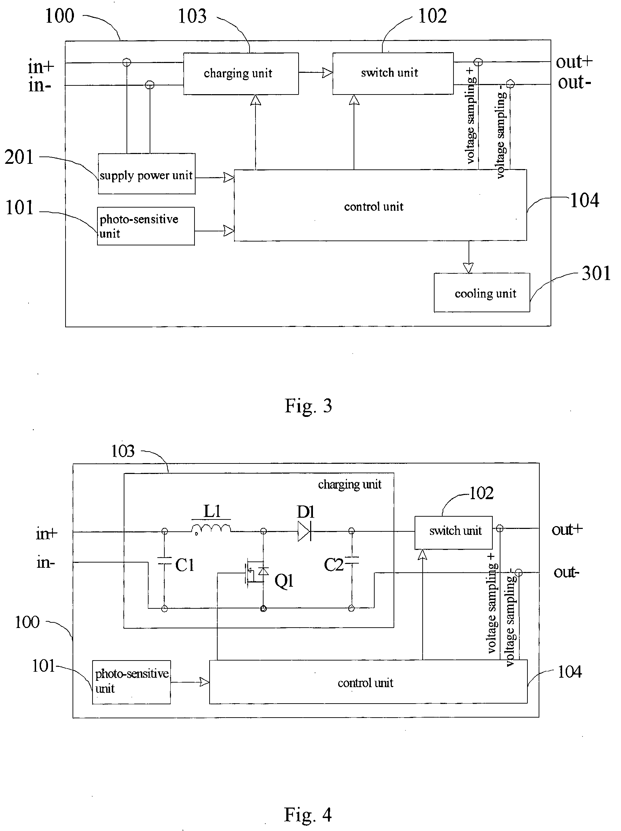

In a third embodiment of the present disclosure, as shown in Fig. 3, the solar charger 100 may further comprise a cooling unit 301 coupled to the control unit 104. The cooling unit 301 is configured to cool the solar charger 100 when a temperature of the solar charger 100 detected by the control unit 104 reaches a third predetermined value. The third predetermined value is about 40 °C to about 100°C, such as 85 °C . Thus, the reliable operation of the solar charger 100 may be ensured. Moreover, the temperature of the solar charger 100 may be detected by a temperature sensor, and because the charging unit 103 is the main energy transforming component, the temperature near the charging unit 103 is preferably detected.

As shown in Figs. 1 to 3, the switch unit 102 is coupled to the positive and negative output terminals of the solar charger 100. It should be understood that, actually, the switch unit 102 may be coupled to one of the positive and negative output terminals (such as the positive output terminal) of the solar charger 100.

In a fourth embodiment, as shown in Fig. 4, the charging unit 103 may comprise a first capacitor C1 having a first end coupled to the positive input terminal of the solar charger 100 and a second end coupled to the negative input terminal of the solar charger 100; a first inductance L1 having a first end coupled to the positive input terminal of the solar charger 100; a first diode D1 having a positive end coupled to a second end of the first inductance L1; a IVIOSFET Q1 having a gate electrode coupled to the control unit 104, a drain electrode coupled to the second end of the first inductance L1, and a source electrode coupled to the second end of the first capacitor C1; and a second capacitor C2 having a first end coupled to a negative end of the first diode D1 and a second end coupled to the second end of the first capacitor C1. The negative end of the diode D1 is coupled to one end of the switch unit 102, the other end of the switch unit 102 is coupled to the positive output terminal of the solar charger 100, and the negative output terminal of the solar charger 100 may be coupled to the negative input terminal thereof, which may ensure that the solar charger 100 will transform from high voltage to high voltage. In Fig. 4, the diode between the source electrode and the drain electrode of the MOSFET Q1 is a built-in diode.

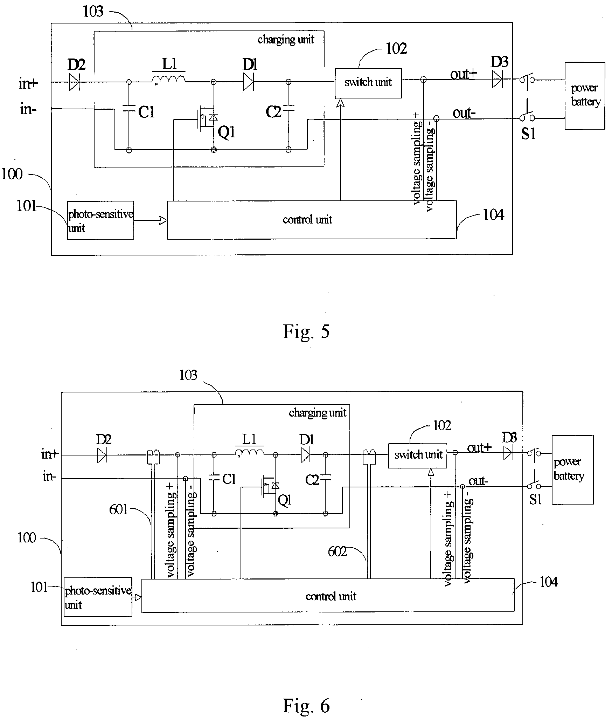

As shown in Fig. 5, in a fifth embodiment of the present disclosure, the solar charger 100 may further comprise a second diode D2 having a positive end coupled to the positive input terminal of the solar charger 100 and a negative end coupled to a positive input of the charging unit 103, which may avoid the damage to the solar charger 100 when the positive and negative input terminals of the solar charger 100 are inversely connected. Meanwhile, the solar charger 100 may further comprise a third diode D3 having a positive end coupled to an output end of the switch unit 102 and a negative end coupled to the power battery, which may avoid the influence of the voltage of the power battery on the output voltage sampling of the solar charger 100 in the charging and non-charging periods

As shown in Fig. 6, in a sixth embodiment of the present disclosure, the solar charger 100 may further comprise a first current sensor 601 configured to detect an input current at the positive input end of the charging unit 103 and to provide the input current detected by the first current sensor 601 to the control unit 104, so that the control unit 104 may adjust the duty ratio of the MOSFET Q1 according to the input current detected by the first current sensor 601 and the voltage inputted into the charging unit 103; thus adjusting the output loading power and then adjusting the output power of the solar harvesting device (not shown) that provides an input voltage to the charging unit 103. Therefore, the solar harvesting device may reach the maximum output power. In Fig. 6, the solar charger 100 further comprises a second current sensor 602 configured to detect an output current at an output end of the charging unit 103 and to provide the output current detected by the second current sensor 602 to the control unit 104. Thus, the control unit 104 may calculate the output loading power and the charging efficiency of the solar charger 100.

The switch unit S1 in the aforementioned Fig. 5 and Fig. 6 is a service switch configured to facilitate the disassembling of the solar charger 100

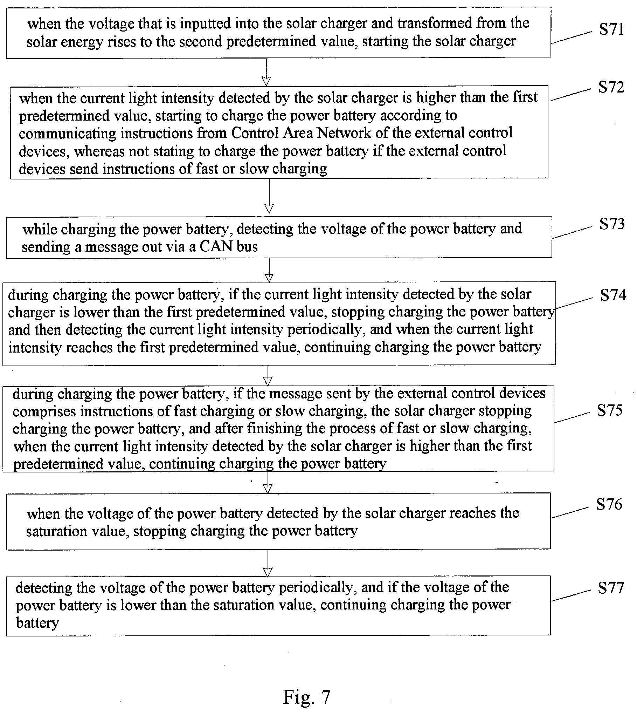

The preferred charging flow of the solar charger 100 may be interpreted as follows in conjunction with the flow chart shown in Fig. 7:
571_{;} when the voltage that is inputted into the solar charger and transformed from the solar energy rises to the second predetermined value (for example, 80 V), starting the solar charger;
572, whey the current light intensity detected by the solar charger is higher than the first predetermined value (for example, a value of no less than 50 lux), starting to charge the power battery according to communicating instructions from Control Area Network (CAN) of the external control devices (such as the battery manager), whereas not stating to charge the poser battery if the external control devices send instructions of fast or slow charging;
S73, while charging the power battery, detecting the voltage of the power battery and sending a message (for example, a message showing a current state of the solar charger) out via a CAN bus;
S74, during charging the power battery, if the current light intensity detected by the solar charger is lower than the first predetermined value, stopping charging the power battery and then detecting the current light intensity periodically (for example, averagely every 3 minutes), and when the current light intensity reaches the first predetermined value, continuing charging the power battery;
S75; during charging the power battery, if the message sent by the external control devices comprises instructions of fast charging or slow charging, the solar charger stopping charging the power battery, and after finishing the process of fast or slow charging, when the current light intensity detected by the solar charger is higher than the first predetermined value, continuing charging the power battery;
S76, when the voltage of the power battery detected by the solar charger reaches the saturation value (for example, 570 V), stopping charging the power battery; and
S77, detecting the voltage of the power battery periodically (for example, at intervals of 30 minutes), and if the voltage of the power battery is lower than the saturation value, continuing charging the power battery.

As is known, the charging flow shown in Fig. 7 is just a preferred flow Some steps in the flow may be omitted or changed according to the actual conditions. For example, after step 577, if the solar charger 100 of the present disclosure receives the instruction of fast charging or slow charging, the process of fast charging or slow charging may be performed first.

By using the above charging flow, not only the purpose of charging the power battery by using solar energy may be achieved, but also the power battery of an electric bus or vehicle may be charged during the driving process, thus not only strengthening the endurance performance of the vehicle, but also retarding the damage to the power battery under large current, protecting the performance of the power battery and prolonging the life of the power battery. Moreover, because the solar charger may operate correspondingly according to different instructions from the external control devices, the operating state of the solar charger may be flexibly controlled.

## Claims

1. A solar charger (100) for charging a power battery, comprising:
aphoto-sensitive unit (101) configured to detect light intensity;
a charging unit (103) configured to receive a voltage transformed from solar energy;
a switch unit (102) coupled between the charging unit (103) and the power battery and configured to disconnect the charging unit (103) from the power battery or connect the charging unit (103) with the power battery; and
a control unit (104) coupled to the photo-sensitive unit (101), the switch unit (102) and the charging unit (103) respectively; and configured to switch on the switch unit (102) when the light intensity is higher than a first predetermined value so as to charge the power battery,
**characterized by**
the charging unit (103) configured to boost the voltage so as to provide the voltage to the power battery;
the control unit (104) configured to switch on the charging unit (103) when the light intensity is higher than a first predetermined value so as to charge the power battery; and
the control unit (104) configured to periodically compare a current light intensity detected by the photo-sensitive unit (101) with the first predetermined value, to switch off the charging unit (103) and the switch unit (102) if the current light intensity is lower than the first predetermined value, and to switch on the charging unit (103) and the switch unit (102) if thy current light intensity is higher than the first predetermined value.

2. The solar charger of claim 1, wherein the control unit (104) is further configured to monitor the voltage of the power battery during charging the power battery, and to switch off the charging unit (103) and the switch unit (102) when the voltage of the power battery reaches a saturation value.

3. The solar charger of claim 1, further comprising
a power supply unit (201) coupled to the control unit (104), and configured to receive and steady the voltage transformed from the solar energy so as to power the control unit (104),
wherein the control unit (104) operates when the voltage transformed from the solar energy reaches a second predetermined value, the second predetermined value being preferably no less than 12 V.

4. The solar charger of claim 2, wherein the control unit (104) is further configured to periodically switch on the switch unit (102) so as to detect a current Voltage of the power battery after the voltage of the power battery reaches a saturation value, and to switch on the charging unit (103) and the switch unit (102) so as to charge the power battery when the current voltage of the power battery is lower than the saturation value and the light intensity detected by the photo-sensitive unit (101) is higher than the first predetermined value.

5. The solar charger of claim 4, wherein a periodic time for periodically switching on the switch unit (102) is 10 to 50 minutes.

6. The solar charger of claim 1, wherein a periodic time for periodically comparing the light intensity with the first predetermined value is 0.5 to 10 minutes.

7. The solar charger of claim 6, wherein the control unit (104) is further configured to communicate with an external control device and to control the charging unit (103) and the switch unit (102) according to instructions from the external control device.

8. The solar charger of claim 7, wherein the control unit (104) is further configured to switch off the charging unit (103) and the switch unit (102) if the control unit (104) receives instructions of fast or slow charging.

9. The solar chargeur of claim 1, further comprising:
a cooling unit (301) coupled to the control unit (104). and configured to cool the solar charger (100) when a temperature of the solar charger (100) detected by the control unit (104) reaches a third predetermined value, the third predetermined value being preferably 40°C to 100°C.

10. The solar charger of claim 1, wherein the first predetermined value is no less than 50 lux.

11. The solar charger of claim 1, wherein the charging unit (103) comprises:
a first capacitor (C1) having a first end coupled to a positive input terminal of the solar charger (100) and a second end coupled to a negative input terminal of the solar charger (100);
a first inductance (L1) having a first end coupled to the positive input terminal of the solar charger (100);
a first diode (D1) having a positive end coupled to a second end of the first inductance
a MOSFET (Q1) having a gate electrode coupled to the control unit (104), a drain electrode coupled to the second end of the first inductance (L1), and a source electrode coupled to the second end of the first capacitor (C1) and
a second capacitor (C2) having a first end coupled to a negative end of the first diode (D1) and a second end coupled to the second end of the first capacitor (C1).

12. The solar charger of claim 11, further comprising
a second diode (D2) having a positive end coupled to the positive input terminal of the solar charger (100) and a negative end coupled to a positive input end of the charging unit (103) and, optionally, a third diode (D3) having a positive end coupled to an output end of the switch unit (102) and a negative end coupled to the power battery.

13. The solar charger of claim 11, further comprising:
a first current sensor (601) configured to detect an input current at the positive input end of the charging unit (103), wherein the control unit (104) adjusts a duty ratio of the MOSFET according to the input current detected by the first current sensor (601).

14. The solar charger of claim 13, further comprising:
a second current sensor (602) configured to detect an output current at an output end off the charging unit (103), wherein the control unit (104) determines a charging efficiency of the solar charger (100) according to the output current detected by the second current sensor (602).

## Patentansprüche

1. Solarladegerät (100) zum Aufladen eines Akkumulators, umfassend:
eine photoempfindliche Einheit (101), die dazu ausgelegt ist, eine Lichtintensität zu erfassen,
eine Aufladeeinheit (103), die dazu ausgelegt ist, eine aus Solarenergie umgewandelte Spannung zu empfangen;
eine Schaltereinheit (102), die zwischen der Aufladeeinheit (103) und dem Akkumulator gekoppelt ist und dazu ausgelegt ist, die Aufladeeinheit (103) von dem Akkumulator zu trennen oder die Aufladeeinheit (103) mit dem Akkumulator zu verbinden; und
eine Steuereinheit (104), die entsprechend mit der photoempfindlichen Einheit (101), der Schaltereinheit (102) und der Aufladeeinheit (103) gekoppelt ist und dazu ausgelegt ist, die Schaltereinheit (102) einzuschalten, wenn die Lichtintensität höher ist als ein erster vorgegebener Wert, um den Akkumulator aufzuladen,
**dadurch gekennzeichnet, dass**
die Aufladeeinheit (103) dazu ausgelegt ist, die Spannung zu verstärken, um dem Akkumulator die Spannung bereitzustellen;
die Steuereinheit (104) dazu ausgelegt ist, die Aufladeeinheit (103) einzuschalten, wenn die Lichtintensität höher ist als ein erster vorgegebener Wert, um den Akkumulator aufzuladen; und
die Steuereinheit (104) dazu ausgelegt ist, periodisch eine aktuelle Lichtintensität, die durch die photoempfindliche Einheit (101) erfasst wird, mit dem ersten vorgegebenen Wert zu vergleichen, um die Aufladeeinheit (103) und die Schaltereinheit (102) auszuschalten, wenn die aktuelle Lichtintensität niedriger ist als der erste vorgegebene Wert, und die Aufladeeinheit (103) und die Schaltereinheit (102) einzuschalten, wenn die aktuelle Lichtintensität höher ist als der erste vorgegebene Wert.

2. Solarladegerät nach Anspruch 1, wobei die Steuereinheit (104) weiterhin dazu ausgelegt ist, während des Aufladens des Akkumulators die Spannung des Akkumulators zu überwachen und die Aufladeeinheit (103) und die Schaltereinheit (102) auszuschalten, wenn die Spannung des Akkumulators einen Sättigungswert erreicht.

3. Solarladegerät nach Anspruch 1, weiterhin umfassend:
eine Energieversorgungseinheit (201), die mit der Steuereinheit (104) gekoppelt ist und dazu ausgelegt ist, die aus der Solarenergie umgewandelte Spannung zu empfangen und zu stabilisieren, um die Steuereinheit (104) zu speisen,
wobei die Steuereinheit (104) in Betrieb ist, wenn die aus der Solarenergie umgewandelte Spannung einen zweiten vorgegebenen Wert erreicht, wobei der zweite vorgegebene Wert vorzugsweise mindestens 12 V beträgt.

4. Solarladegerät nach Anspruch 2, wobei die Steuereinheit (104) weiterhin dazu ausgelegt ist, periodisch die Schaltereinheit (102) einzuschalten, um eine aktuelle Spannung des Akkumulators zu erfassen, nachdem die Spannung des Akkumulators einen Sättigungswert erreicht, und die Aufladeeinheit (103) und die Schaltereinheit (102) einzuschalten, um den Akkumulator aufzuladen, wenn die aktuelle Spannung des Akkumulators niedriger ist als der Sättigungswert und die durch die photoempfindliche Einheit (101) erfasste Lichtintensität höher ist als der erste vorgegebene Wert.

5. Solarladegerät nach Anspruch 4, wobei eine Periodenzeit zum periodischen Einschalten der Schaltereinheit (102) 10 bis 50 Minuten beträgt.

6. Solarladegerät nach Anspruch 1, wobei eine Periodenzeit zum periodischen Vergleichen der Lichtintensität mit dem ersten vorgegebenen Wert 0,5 bis 10 Minuten beträgt.

7. Solarladegerät nach Anspruch 6, wobei die Steuereinheit (104) weiterhin dazu ausgelegt ist, mit einer externen Steuervorrichtung zu kommunizieren und die Aufladeeinheit (103) und die Schaltereinheit (102) gemäß Befehlen von der externen Steuervorrichtung zu steuern.

8. Solarladegerät nach Anspruch 7, wobei die Steuereinheit (104) weiterhin dazu ausgelegt ist, die Aufladeeinheit (103) und die Schaltereinheit (102) auszuschalten, wenn die Steuereinheit (104) Befehle zum schnellen oder langsamen Aufladen empfängt.

9. Solarladegerät nach Anspruch 1, weiterhin umfassend:
eine Kühleinheit (301), die mit der Steuereinheit (104) gekoppelt ist und dazu ausgelegt ist, das Solarladegerät (100) zu kühlen, wenn eine durch die Steuereinheit (104) erfasste Temperatur des Solarladegeräts (100) einen dritten vorgegebenen Wert erreicht, wobei der dritte vorgegebene Wert vorzugsweise 40°C bis 100°C beträgt.

10. Solarladegerät nach Anspruch 1, wobei der erste vorgegebene Wert mindestens 50 Lux beträgt.

11. Solarladegerät nach Anspruch 1, wobei die Aufladeeinheit (103) umfasst:
einen ersten Kondensator (C1), der ein erstes Ende, das mit einem positiven Eingangsanschlusspunkt des Solarladegeräts (100) gekoppelt ist, und ein zweites Ende, das mit einem negativen Eingangsanschlusspunkt des Solarladegeräts (100) gekoppelt ist, aufweist;
eine erste Induktivität (L1), die ein erstes Ende aufweist, das mit dem positiven Eingangsanschlusspunkt des Solarladegeräts (100) gekoppelt ist;
eine erste Diode (D1), die ein positives Ende aufweist, das mit einem zweiten Ende der ersten Induktivität (L1) gekoppelt ist;
einen MOSFET (Q1), der eine Gate-Elektrode, die mit der Steuereinheit (104) gekoppelt ist, eine Drain-Elektrode, die mit dem zweiten Ende der ersten Induktivität (L1) gekoppelt ist, und eine Source-Elektrode, die mit dem zweiten Ende des ersten Kondensators (C1) gekoppelt ist, aufweist; und
einen zweiten Kondensator (C2), der ein erstes Ende, das mit einem negativen Ende der ersten Diode (D1) gekoppelt ist, und ein zweites Ende, das mit dem zweiten Ende des ersten Kondensators (C1) gekoppelt ist, aufweist.

12. Solarladegerät nach Anspruch 11, weiterhin umfassend:
eine zweite Diode (D2), die ein positives Ende, das mit dem positiven Eingangsanschlusspunkt des Solarladegeräts (100) gekoppelt ist, und ein negatives Ende, das mit einem positiven Eingangsende der Aufladeeinheit (103) gekoppelt ist, aufweist, und optional eine dritte Diode (D3), die ein positives Ende, das mit einem Ausgangsende der Schaltereinheit (102) gekoppelt ist, und ein negatives Ende, das mit dem Akkumulator gekoppelt ist, aufweist.

13. Solarladegerät nach Anspruch 11, weiterhin umfassend:
einen ersten Stromsensor (601), der dazu ausgelegt ist, an dem positiven Eingangsende der Aufladeeinheit (103) einen Eingangsstrom zu erfassen, wobei die Steuereinheit (104) gemäß dem durch den ersten Stromsensor (601) erfassten Eingangsstrom ein Tastverhältnis des MOSFET einstellt.

14. Solarladegerät nach Anspruch 13, weiterhin umfassend:
einen zweiten Stromsensor (602), der dazu ausgelegt ist, an einem Ausgangsende der Aufladeeinheit (103) einen Ausgangsstrom zu erfassen, wobei die Steuereinheit (104) gemäß dem durch den zweiten Stromsensor (602) erfassten Ausgangsstrom einen Ladewirkungsgrad des Solarladegeräts (100) bestimmt.

## Revendications

1. Chargeur solaire (100) pour charger un accumulateur électrique, comprenant
une unité photosensible (101) configurée pour détecter une intensité lumineuse ;
une unité de charge (103) configurée pour recevoir une tension transformée à partir de l'énergie solaire ;
une unité de commutation (102) couplée entre l'unité de charge (103) et l'accumulateur électrique et configurée pour déconnecter l'unité de charge (103) de l'accumulateur électrique ou pour connecter l'unité de charge (103) à l'accumulateur électrique ; et
une unité de commande (104) couplée respectivement à l'unité photosensible (101), à l'unité de commutation (102) et à l'unité de charge (103), et configurée pour mettre en circuit l'unité de commutation (102) quand l'intensité lumineuse est supérieure à une première valeur prédéterminée de façon à charger l'accumulateur électrique,
**caractérisé par**
l'unité de charge (103) configurée pour amplifier la tension de façon à fournir la tension à l'accumulateur électrique ;
l'unité de commande (104) configurée pour mettre en circuit l'unité de charge (103) quand l'intensité lumineuse est supérieure à une première valeur prédéterminée de façon à charger l'accumulateur électrique ; et
l'unité de commande (104) configurée pour comparer périodiquement une intensité lumineuse actuelle détectée par l'unité photosensible (101) avec la première valeur prédéterminée, pour mettre hors circuit l'unité de charge (103) et l'unité de commutation (102) si l'intensité lumineuse actuelle est inférieure à la première valeur prédéterminée, et pour mettre en circuit l'unité de charge (103) et l'unité de commutation (102) si l'intensité lumineuse actuelle est supérieure à la première valeur prédéterminée.

2. Chargeur solaire selon la revendication 1, dans lequel l'unité de commande (104) est également configurée pour surveiller la tension de l'accumulateur électrique pendant le chargement de l'accumulateur électrique , et pour mettre hors circuit l'unité de charge (103) et l'unité de commutation (102) quand la tension de l'accumulateur électrique atteint une valeur de saturation.

3. Chargeur solaire selon la revendication 1, comprenant également
une unité d'alimentation électrique (201) couplée à l'unité de commande (104), et configurée pour recevoir et stabiliser la tension transformée à partir de l'énergie solaire de façon à alimenter l'unité de commande (104),
dans lequel l'unité de commande (104) agit quand la tension transformée à partir de l'énergie solaire atteint une deuxième valeur prédéterminée, la deuxième valeur prédéterminée ne dépassant pas de préférence 12 V.

4. Chargeur solaire selon la revendication 2, dans lequel l'unité de commande (104) est également configurée pour mettre périodiquement en circuit l'unité de commutation (102) de façon à détecter une tension actuelle de l'accumulateur électrique après que la tension de l'accumulateur électrique a atteint une valeur de saturation, et pour mettre en circuit l'unité de charge (103) et l'unité de commutation (102) de façon à charger l'accumulateur électrique quand la tension actuelle de l'accumulateur électrique est inférieure à la valeur de saturation et quand l'intensité lumineuse détectée par l'unité photosensible (101) est supérieure à la première valeur prédéterminée.

5. Chargeur solaire selon la revendication 4, dans lequel une durée périodique pour mettre périodiquement en circuit l'unité de commutation (102) est comprise entre 10 et 50 minutes.

6. Chargeur solaire selon la revendication 1, dans lequel une durée périodique pour comparer périodiquement l'intensité lumineuse avec la première valeur prédéterminée est comprise entre 0,5 et 10 minutes.

7. Chargeur solaire selon la revendication 6, dans lequel l'unité de commande (104) est également configurée pour communiquer avec un dispositif de commande externe et pour commander l'unité de charge (103) et l'unité de commutation (102) en fonction d'instructions en provenance du dispositif de commande externe.

8. Chargeur solaire selon la revendication 7, dans lequel l'unité de commande (104) est également configurée pour mettre hors circuit l'unité de charge (103) et l'unité de commutation (102) si l'unité de commande (104) reçoit des instructions de charge rapide ou lente.

9. Chargeur solaire selon la revendication 1, comprenant également:
une unité de refroidissement (301) couplée à l'unité de commande (104), et configurée pour refroidir le chargeur solaire (100) quand une température du chargeur solaire (100) détectée par l'unité de commande (104) atteint une troisième valeur prédéterminée, la troisième valeur prédéterminée étant de préférence comprise entre 40° C et 100° C.

10. Chargeur solaire selon la revendication 1, dans lequel la première valeur prédéterminée n'est pas inférieure à 50 lux.

11. Chargeur solaire selon la revendication 1, dans lequel l'unité de charge (103) comprend :
un premier condensateur (C1) ayant une première extrémité couplée à une borne d'entrée positive du chargeur solaire (100) et une deuxième extrémité couplée à une borne d'entrée négative du chargeur solaire (100) ;
une première inductance (L1) ayant une première extrémité couplée à la borne d'entrée positive du chargeur solaire (100) ;
une première diode (D1) ayant une extrémité positive couplée à une deuxième extrémité de la première inductance (L1) ;
un MOSFET (Q1) ayant une électrode de grille couplée à l'unité de commande (104), une électrode de drain couplée à la deuxième extrémité de la première inductance (L1), et une électrode de source couplée à la deuxième extrémité du premier condensateur (C1) ; et
un deuxième condensateur (C2) ayant une première extrémité couplée à une extrémité négative de la première diode (D1) et une deuxième extrémité couplée à la deuxième extrémité du premier condensateur (C1).

12. Chargeur solaire selon la revendication 11, comprenant :
une deuxième diode (D2) ayant une extrémité positive couplée à la borne d'entrée positive du chargeur solaire (100) et une extrémité négative couplée à une extrémité d'entrée positive de l'unité de charge (103) et, en option, une troisième diode (D3) ayant une extrémité positive couplée à une extrémité de sortie de l'unité de commutation (102) et une extrémité négative couplée à l'accumulateur électrique.

13. Chargeur solaire selon la revendication 11, comprenant également
un premier capteur de courant (601) configuré pour détecter un courant d'entrée à l'extrémité d'entrée positive de l'unité de charge (103), dans lequel l'unité de commande (104) ajuste un rapport cyclique du MOSFET en fonction du courant d'entrée détecté par le premier capteur de courant (601).

14. Chargeur solaire selon la revendication 13, comprenant également :
un deuxième capteur de courant (602) configuré pour détecter un courant de sortie d'une extrémité de sortie de l'unité de charge (103), dans lequel l'unité de commande (104) détermine un rendement de charge du chargeur solaire (100) en fonction du courant de sortie détecté par le deuxième capteur de courant (602).
